# EUROPÄISCHE PATENTSCHRIFT

(11) **EP 2 276 878 B1**
(45) Veröffentlichungstag und Bekanntmachung des Hinweises auf die Patenterteilung: **19.11.2014**
(21) Anmeldenummer: 09776890.7
(22) Anmeldetag: 30.06.2009
(51) Int. Cl.: C30B 29/42, C30B 15/04, C30B 11/00

(54) **VERFAHREN ZUR HERSTELLUNG VON DOTIERTEN GALLIUMARSENIDSUBSTRATWAFERN MIT NIEDRIGEM OPTISCHEN ABSORPTIONSKOEFFIZIENTEN**
METHOD FOR PRODUCING DOPED GALLIUM ARSENIDE SUBSTRATE WAFERS WITH A LOW OPTICAL ABSORPTION COEFFICIENT
PROCÉDÉ DE FABRICATION DE PLAQUETTES D'ARSÉNIURE DE GALLIUM DOPÉES À FAIBLES COEFFICIENTS D'ABSORPTION OPTIQUE

(30) Priorität: 11.07.2008 DE 102008032628; 11.07.2008 US 79902 P
(43) Veröffentlichungstag der Anmeldung: 26.01.2011
(73) Patentinhaber: Freiberger Compound Materials GmbH, 09599 Freiberg (DE)
(72) Erfinder: KRETZER, Ulrich, 09116 Chemnitz (DE); BÖRNER, Frank, 01069 Dresden (DE); EICHLER, Stefan, 01187 Dresden (DE); KROPFGANS, Frieder, 07743 Jena (DE)
(74) Vertreter: Prüfer & Partner GbR European Patent Attorneys
(86) Internationale Anmeldenummer: PCT/EP2009/004717
(87) Internationale Veröffentlichungsnummer: WO 2010/003573

(56) Entgegenhaltungen:
- EP-A2- 0 206 541
- JP-A- 2004 099 390
- JP-A- 2004 115 339
- JP-A- 2004 137 096
- US-A- 5 612 014
- US-A1- 2004 187 768
- W. G. SPITZER, J.M. WHELAN: "Infrared absorption and electron effective mass in n-type gallium arsenide" PHYSICAL REVIEW, Bd. 114, Nr. 1, 1. April 1959 (1959-04-01), Seiten 59-63, XP002546482 in der Anmeldung erwähnt
- J. LAGOWSKI, H.C. GATOS, J.M. PARSEY K. WADA, M. KAMINSKA, W. WALUKIEWICZ: "Origin of the 0.82eV electron trap in GaAs and its annihilation by shallow donors" APPLIED PHYSICS LETTERS, Bd. 40, 15. Februar 1982 (1982-02-15), Seiten 342-344, XP002546483 in der Anmeldung erwähnt
- G. M. MARTIN: "Optical assessment of the main electron trap in bulk semi-insulating GaAs" APPLIED PHYSICS LETTERS, Bd. 39, 1. November 1981 (1981-11-01), Seiten 747-748, XP002546484 in der Anmeldung erwähnt
- WENZL H ET AL: "Phase relations in GaAs crystal growth", JOURNAL OF CRYSTAL GROWTH, ELSEVIER, AMSTERDAM, NL, vol. 109, no. 1-4, 2 February 1991 (1991-02-02), pages 191-204, XP024450590, ISSN: 0022-0248, DOI: DOI:10.1016/0022-0248(91)90178-8 [retrieved on 1991-02-02]
- HURLE D T J: "A comprehensive thermodynamic analysis of native point defect and dopant solubilities in gallium arsenide", JOURNAL OF APPLIED PHYSICS, AMERICAN INSTITUTE OF PHYSICS. NEW YORK, US, vol. 85, no. 10, 15 May 1999 (1999-05-15), pages 6957-7022, XP012046296, ISSN: 0021-8979, DOI: DOI:10.1063/1.370506
- NISHIO J ET AL: "Theoretical analysis for the segregation in the liquid encapsulated Czochralski system", JOURNAL OF CRYSTAL GROWTH, ELSEVIER, AMSTERDAM, NL, vol. 141, no. 1-2, 1 August 1994 (1994-08-01), pages 249-255, XP024517832, ISSN: 0022-0248, DOI: DOI:10.1016/0022-0248(94)90118-X [retrieved on 1994-08-01]
- NEWMAN R ET AL: "THE LATTICE LOCATIONS OF SILICON IMPURITIES IN GAAS: EFFECTS DUE TO STOICHIOMETRY, THE FERMI ENERGY, THE SOLUBILITY LIMIT AND DX BEHAVIOUR", SEMICONDUCTOR SCIENCE AND TECHNOLOGY, IOP PUBLISHING LTD, GB, vol. 9, no. 10, 1 October 1994 (1994-10-01), pages 1749-1762, XP000670372, ISSN: 0268-1242, DOI: 10.1088/0268-1242/9/10/001
- KORB J ET AL: "Carbon, oxygen, boron, hydrogen and nitrogen in the LEC growth of SI GaAs: a thermochemical approach", JOURNAL OF CRYSTAL GROWTH, ELSEVIER, AMSTERDAM, NL, vol. 198-199, 1 March 1999 (1999-03-01), pages 343-348, XP004170877, ISSN: 0022-0248, DOI: 10.1016/S0022-0248(98)01089-6
- TAKUYA KITAMOTO ET AL: "Optical measurement of carrier concentration profile in n-type semiconducting GaAs substrate", PHYSICA STATUS SOLIDI (A), vol. 204, no. 4, 1 April 2007 (2007-04-01) , pages 1002-1007, XP55011712, ISSN: 1862-6300, DOI: 10.1002/pssa.200674160
- OSAMURA K ET AL: "Free carrier absorption in n-GaAs", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 11, no. 3, 1 March 1972 (1972-03-01), pages 365-371, XP008145350, ISSN: 0021-4922, DOI: 10.1143/JJAP.11.365
- KOZLOVA J P ET AL: "A comparative study of EL2 and other deep centers in undoped SI GaAs using optical absorption spectra and photoconductivity measurements", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, vol. 512, no. 1-2, 11 October 2003 (2003-10-11), pages 1-7, XP004468048, ISSN: 0168-9002, DOI: 10.1016/S0168-9002(03)01871-0
- HAGI Y ET AL: "Low dislocation density 3-inch Si doped GaAs crystals by Vertical Boat growth", SEMICONDUCTING AND SEMI-INSULATING MATERIALS CONFERENCE, 1996. IEEE TOULOUSE, FRANCE 29 APRIL-3 MAY 1996, NEW YORK, NY, USA,IEEE, US, 29 April 1996 (1996-04-29), pages 279-282, XP010213077, DOI: 10.1109/SIM.1996.571099 ISBN: 978-0-7803-3179-2
- D.E. HOLMES, R.T. CHEN, K.R. ELLIOTT, C.G. KIRKPATRICK: "stoichiometry-controlled compensation in liquid encapsulated czochralski GaAs", APPL. PHYS. LETT., vol. 40, 1 January 1982 (1982-01-01), pages 46-48,
- H. C. Casey ET AL: "Concentration dependence of the absorption coefficient for n- and p-type GaAs between 1.3 and 1.6 eV", Journal of Applied Physics, vol. 46, no. 1, 1 January 1975 (1975-01-01), page 250, XP055077128, ISSN: 0021-8979, DOI: 10.1063/1.321330

## Beschreibung

Die Erfindung betrifft ein Verfahren zur Herstellung von Galliumarsenid-Einkristallen durch Erstarrung einer Schmelze des Halbleitermaterials, unter Verwendung eines Keimkristalls aus dem gleichen Halbleitermaterial wie der herzustellende Halbleiter-Einkristall.

Für die Anwendung von Galliumarsenid-Substratwafern zur Herstellung von lichtemittierenden Bauelementen, wie Halbleiterlasern und Lumineszenzdioden wird in der Regel eine hohe elektrische Leitfähigkeit der Substratwafer gefordert. In speziellen Bauelementen wird die Lichtstrahlung im Substratwafer selbst erzeugt oder durchläuft ihn parallel oder senkrecht zur Waferoberfläche. In den genannten Bauelementen treten in der Regel hohe elektrische und optische Leistungsdichten auf. Versetzungen, die die aktiven Schichten der Bauelemente durchlaufen, können bei hohen Leistungsdichten zu einer Degradation und zum Ausfall des Bauelements führen.

In [14] wird ein Verfahren zur Herstellung von Silicium-dotierten Galliumarsenid-Einkristallen mit Hilfe der Vertical Bridgman - Methode (VB) oder der Vertical Gradient Freeze - Methode (VGF) beschrieben. Die beanspruchten Eigenschaften der aus den Kristallen gefertigten Substratwafer umfassen eine Ladungsträgerkonzentration von (0.1 - 5.0) 10¹⁸ cm⁻³ und eine Versetzungsdichte von 5000 cm⁻² oder weniger. Für Bauelemente mit hohen elektrischen und optischen Leistungsdichten ist eine wesentlich niedrigere Versetzungsdichte erforderlich.

Die Versetzungsdichte von Halbleiterkristallen lässt sich durch Hinzufügen eines Dotierstoffs, der eine Härtung des Kristallgitters bewirkt, vermindern. In [15] wird eine Methode beschrieben, mit der sich durch eine zusätzliche Dotierung mit Silicium die Versetzungsdichte von p-leitendenden, Zink-dotierten Galliumarsenidkristallen auf Werte unter 500 cm⁻² vermindern lässt. Eine Methode zur weiteren Verringerung der Versetzungsdichte wird in [16] beschrieben. Durch die zusätzliche Dotierung der Kristalle mit Elementen, die isoelektronisch in das Kristallgitter von Galliumarsenid eingebaut werden, z.B. Indium, lässt sich die Versetzungsdichte in p-leitenden Galliumarsenidkristallen auf Werte von unter 100 cm⁻² vermindern.

Galliumarsenid-Einkristalle sind bei Raumtemperatur für elektromagnetische Strahlung im nahen Infrarot mit Photonenenergien, die kleiner sind als die Energie der Bandlücke, transparent. Die Wellenlänge der elektromagnetischen Strahlung muss dafür größer als 870 nm sein. Der Transmissionsgrad wird für Wellenlängen zwischen 900 nm und 4 µm von zwei Wechselwirkungsprozessen der Photonen der einfallenden elektromagnetischen Strahlung mit Elektronen des Galliumarsenid-Einkristalls bestimmt. Im ersten Prozess werden Elektronen durch Absorption von Photonen aus einem niedrigen Energieniveau des Leitungsbandes in ein höheres Energieniveau angehoben (siehe [1]). Der Absorptionskoeffizient α_{ib}, der diesem Prozess zugeordnet wird, ist für eine gegebene Wellenlänge proportional zur Konzentration der Elektronen im Leitungsband. Diese entspricht in Kristallen mit einer elektrischen Leitfähigkeit vom n-Typ der Ladungsträgerkonzentration *n.* Der Proportionalitätsfaktor ist abhängig von der Wellenlänge λ und hat beispielsweise für λ = 2 µm einen Wert von 6·10⁻¹⁸cm² [2], [3]. Die herkömmliche Forderung nach hoher Ladungsträgerkonzentration läuft somit dem Ziel zuwider, niedrige Absorptionskoeffizienten zu erreichen.

Der zweite Prozess besteht in der lichtinduzierten Anregung von Elektronen aus dem energetischen Niveau EL2 ins Leitungsband [4]. Das EL2-Niveau wird von Arsen-Antistrukturdefekten As_{Ga} erzeugt [5], [6], man bezeichnet diesen Defekt daher auch als EL2-Defekt. Der zugehörige Absorptionskoeffizient α_{EL2} ist proportional zur Konzentration von As_{Ga} im Kristall. Der Proportionalitätsfaktor ist abhängig von der Wettentänge λ und entspricht in Kristallen mit hoher Leitfähigkeit vom n-Typ dem optischen Absorptionsquerschnitt σₙ^{o} des EL2-Defekts im neutralen Ladungszustand. Experimentelle Werte für den Absorptionsquerschnitt σₙ^{o} sind in [7] veröffentlicht.

Die Konzentration der EL2-Defekte in einem Galliumarsenid-Einkristall wird maßgeblich durch die Zusammensetzung der Galliumarsenid-Schmelze bestimmt, durch deren Erstarrung der Einkristall erzeugt wird. Kristalle, die aus stöchiometrischen oder arsenreichen Schmelzen erstarren, enthalten EL2-Defekte im Konzentrationsbereich von (1 - 2)·10¹⁶ cm⁻³. In Kristallen, die nur eine geringe Konzentration von Fremdstoffen und einen geringen Überschuß an akzeptorischen Defekten enthalten, führte die Anwesenheit von EL2-Defekten in diesem Konzentrationsbereich zu einer sehr geringen elektrischen Leitfähigkeit [8]. Zur Erzeugung solcher Kristalle wurden daher gewöhnlich Schmelzen verwendet, in denen der Arsen-Molenbruch *x*_{As} / (*x*_{As} + *x*_{Ga}) mindestens 0,5 beträgt. In [9] wird das Ziel verfolgt, im gesamten axialen Verlauf des Kristalls eine möglichst homogene EL2-Konzentration im Bereich von 0,8-1,4x10¹⁶cm⁻³ zu erzielen. Beim Vergleich von Kristalle, die aus Schmelzen mit unterschiedliche Arsen-Molenbrüchen erzeugt wurden, wurde gefunden, daß die gewünschte EL2-Homogenität erreicht wird, wenn der Arsen-Molenbruch der Schmelze stabil 0,5 beträgt. Experimentelle Daten in [10] zeigen eine Abhängigkeit der EL2-Konzentration vom Arsen-Molenbruch für Kristalle, die nach dem LEC-Verfahren erzeugt wurden.

Die Konzentration der EL2-Defekte kann stark verringert werden, wenn die Kristalle mit Dotierstoffen dotiert werden, die eine hohe Leitfähigkeit vom n-Typ erzeugen (vgl. [11]). Thermodynamische Berechnungen zeigen, dass die Größe des Arsen-Molenbruchs die Konzentration der EL2-Defekte beeinflußt (vgl. [12]).

Die in den Literaturstellen [9] und [10] gezeigte Abhängigkeit der EL2-Konzentration vom Arsen-Molenbruch der Schmelze, aus der ein Galliumarsenidkristall erstarrt wird, wurde dort auf ihre Auswirkung auf den spezifischen elektrischen Widerstand und die elektrische Leitfähigkeit in diesen Kristallen betrachtet. In [9] wird die EL2-Konzentration der Kristalle in Beziehung gesetzt zu Eigenschaften der aus den Substratwafern erzeugten MESFET. Nach den dort beschriebenen Maßnahmen beeinflusst die Höhe der EL2-Konzentration das Hochfrequenzverhalten dieser Bauelemente. Es wird kein Bezug auf eine mögliche Veränderung des optischen Absorptionskoeffizienten genommen, da kein Zusammenhang zwischen dem optischen Absorptionskoeffizienten des Substratwafers und den Eigenschaften eines aus diesem Substratwafers erzeugten MESFET besteht.

JP-A-2004-115339 offenbart eine Herstellungsmethode für GaAs-Einkristalle, die das Einbringen von Borarsenid-Kristallkeimen zwischen GaAs-Schmelze und Boroxid-Abdeckschmelze umfasst, um entstehendes Borarsenid an der Grenzfläche zwischen GaAs-Schmelze und Boroxid-Abdeckschmelze abzufangen. In Physical review, 114,1,59 - 63 (1959) ist eine Untersuchung zur IR-Absorption von n-dotierten GaAs-Einkristallen in Abhängigkeit der Ladungsträgerkonzentration offenbart. US 5,612,014 offenbart die Herstellung von Halbleitermaterialien, die GaAs mit verschiedenen Dotierungselementen wie beispielsweise Silizium, Schwefel, Selen, Germanium, Tellur und Zinn umfassen, die ferner in kristalliner Form anfallen und eine hohe Ladungsträgerkonzentration und eine geringe Versetzungsdichte aufweisen. In Journal of Crystal growth 109, 191 - 204 (1991) sind die Phasenbeziehungen zwischen Gas-, Flüssig- und Festphase im binären System GaAs zusammengefasst sowie die Bedingungen offenbart, unter denen aus einer GaAs-Schmelze Arsen als Gas entweichen kann. In Journal of Crystal growth 171, 249 - 255 (1994) ist eine theoretische Analyse zu Verunreinigungen in GaAs-Schmelzen offenbart, mittels derer der Verteilungskoeffizient für Borverunreinigungen in einer GaAs-Schmelze berechnet werden kann.

Die Veröffentlichung von Spitzer und Whelan (entsprechend [2]) beschreiben Untersuchungen und Messungen zur Infrarotabsorption im Wellenlängenbereich 850nm bis 25µm als Funktion der Ladungsträgerkonzentration von dotierten Galliumarsenid-Einkristallen, die mittels der "floating zone"-Methode hergestellt wurden. Als Dotierstoffe wurden Se und Te untersucht, jeweils mit Elektronenkonzentrationen von 1,3x10¹⁷ sowie 1,09, 1,12 und 5,4x10¹⁸ cm⁻³.

In der Veröffentlichung von Kitamoto et al., phys. stat. sol. (a) 204, Nr. 4 (2007), S. 1002-1007 zeigen die Autoren, dass in Si-dotierten GaAs-Kristallen unterhalb einer bestimmten Ladungsträgerkonzentration eine Absorption durch EL2-Defekte auftritt. Die Autoren weisen darauf hin, dass ein solches Phänomen zu berücksichtigen ist, wenn aus dem optischen Absorptionskoeffizienten auf die Ladungsträgerkonzentration geschlossen werden soll. Während die Beziehung zwischen optischem Absorptionskoeffizienten und Ladungsträgerkonzentration im Wellenlängenbereich von 1500nm oder höher näherungsweise proportional ist, zeigen die Autoren bei kürzeren Wellenlängen, dass die Absorptionsbande des EL2 die Absorption durch freie Ladungsträger überlagert. Somit weicht bei diesem kritischen niedrigeren Wellenlängenbereich die tatsächliche Beziehung zwischen Absorption und Ladungsträgerkonzentration von der Proportionalität ab.

Osamura und Murakami (Japanese Journal of Applied Physics, 11, Nr. 3 (1972), S. 365-371) beschreiben den Einfluss der Absorption freier Ladungsträger in n-GaAs im Wellenlängenbereich von 2,5 bis 25µm. In diesem Bereich entsprechen die gezeigten theoretischen Kurven einer Absorption durch Streuung an freien Ladungsträgern.

Die Veröffentlichung Hage et al., IEEE 1996, S. 279-282, beschäftigt sich mit der Herstellung von Si-dotierten GaAs-Kristallen mit niedriger Versetzungsdichte von ≤ 1000 m⁻². Hierzu wird die Form der Fest/Flüssig-Grenzfläche untersucht und gesteuert.

Die Veröffentlichung von Kozlowa et al. in Nuclear Instruments and Methods in Physics Research A 512 (2003), S. 1-7 beschreibt eine Untersuchung, wie EL2 und andere tiefe Zentren in undotiertem, semi-isolierendem (SI)GaAs optische Absorptionsspektren und Fotoleitfähigkeitsmessungen beeinträchtigen. Dies erfolgt vor dem Hintergrund, dass optische Absorptionsmessungen im nahen Infrarotbereich häufig zur Bestimmung der EL2-Konzentration und somit zur Abschätzung der EL2⁺-Konzentration verwendet werden. Aus den Untersuchungen wird geschlossen, dass insbesondere auch ionisierte EL3⁺-Defekte zur erhöhten Absorption beitragen.

Aufgabe der Erfindung ist es, ein Verfahren zur Erzeugung von Galliumarsenid-Einkristallen mit geringem optischen Absorptionskoeffizienten sowie solche Galliumarsenid-Einkristallen an sich bereitzustellen. Wünschenswert wäre ferner, dabei gleichzeitig den Problemen von einerseits einer ausreichenden elektrischen Leitfähigkeit, vorzugsweise einer solchen vom n-Typ, und andererseits einer Bereitstellung geringer Versetzungsdichten Rechnung zu tragen.

Gemäß einem Gegenstand wird die Aufgabe gelöst durch ein Verfahren gemäß Anspruch 1. Bevorzugte Ausgestaltungen des erfindungsgemäßen Verfahrens sind in den Unteransprüchen zu Anspruch 1 festgelegt.

Gemäß einem weiteren Gegenstand wird die Aufgabe gelöst durch einen GaAs-Einkristall, der alternativ gemäß Anspruch 6 oder gemäß Anspruch 7 definiert ist. Bevorzugte Ausgestaltungen des erfindungsgemäßen Einkristalls sind in den Unteransprüchen zu Anspruch 6 oder 7 festgelegt.

Gemäß einem noch weiteren Gegenstand wird erfindungsgemäß ein Galliumarsenid-Substratwafer bereitgestellt, der aus einem wie oben definierten Galliumarsenid-Einkristall gebildet ist. Die oben und unten detaillierter beschriebenen, für den Einkristall definierten Merkmale gelten für die daraus vereinzelten Wafer entsprechend.

Erfindungsgemäß wurden kritische Faktoren und Bedingungen gefunden, wie trotz gegenläufiger Wirkungen der als relevant erkannten Wirkungsmechanismen gleichzeitig eine hohe elektrische Leitfähigkeit, insbesondere solche vom n-Typ, mit einem niedrigen optischen Absorptionskoeffizienten im nahen Infrarot, insbesondere für elektromagnetische Strahlung mit einer Wellenlänge im Bereich von 900 nm bis 1700 nm, und einer mittleren Ätzgrubendichte von höchstens 500 cm⁻² kombinierbar sind. Verfahrenstechnisch wird dies durch kritische Beachtung sowohl eines Überschusses an Gallium in der Galliumarsenid-Schmelze, als auch einer erforderlichen Mindestkonzentration an Bor realisiert. Produktspezifisch ist erfindungsgemäß ein bestimmter Ladungsträgerkonzentrationsbereich einstellbar, in dem signifikant verbesserte Parameter des optischen Absorptionskoeffizienten bewirkt und gleichzeitig dem Erfordernis einer ausreichenden Ladungsträgerkonzentration Rechnung getragen werden. Darüber hinaus kann eine vorteilhafte, geringe Flächendichte von Versetzungsätzgruben auf Querschnittsflächen senkrecht zur Kristallachse eingehalten werden.

Der erfindungsgemäß erhältliche Galliumarsenid-Einkristall zeichnet sich insbesondere durch eine einzigartige Kombination aus niedriger Versetzungsdichte, hoher Leitfähigkeit und dennoch ausgezeichneter, sehr niedriger optischer Absorption insbesondere im IR-Bereich, und dort vor allem im nahen Infrarot, aus.

Mit den erfindungsgemäß erzielbaren Merkmalen und Eigenschaften sind die erhaltenen Kristalle und die daraus erzeugten Substratwafer hervorragend für die Verwendung bei der Herstellung optoelektronischer Bauelemente geeignet, bei denen die erzeugte Strahlung den Substratwafer parallel oder senkrecht zur Waferoberfläche durchläuft. Da der optische Absorptionskoeffizient des Halbleitermaterials, mit dem der Substratwafer gebildet wird, im vorbezeichneten spektralen Bereich der erzeugten Strahlung trotz der relativ hohen Leitungsträgerkonzentrationen sehr niedrig gehalten werden kann, zeigen die mit dem erfindungsgemäßen Wafer hergestellten Bauelemente eine hohe Effizienz. Die Gefahr von Degradation und Ausfall des Bauelements, welche aufgrund von hohen elektrischen und optischen Leistungsdichten in den aktiven Schichten der Bauelemente hervorgerufen werden kann, wird durch die gleichzeitig erzielbare sehr geringe Flächendichte von Versetzungsätzgruben als Maß für die Versetzungsdichte gemindert oder sogar vollkommen unterdrückt. Die erfindungsgemäß erreichbaren sehr geringen Versetzungsdichten, die je nach Anwendungen auf kleiner als 1500 cm⁻² und sogar kleiner als 500 cm⁻² eingesellt werden kann, sorgt für eine vorteilhafte lange Lebensdauer der mit den erfindungsgemäßen Substratwafern hergestellten Bauelemente.

Die Erfindung, deren Vorteile und bevorzugte Ausführungsformen sowie Beispiele werden nachfolgend unter Bezugnahme auf die Figuren näher beschrieben, wobei Ausführungsformen, Beispiele und Figuren jedoch nur zur Veranschaulichung dienen und die Erfindung in keiner Weise einschränken.
Fig. 1 zeigt in Beispielen Topogramme der lokalen Versetzungsätzgrubendichte, die als Maß für die Versetzungsdichte dient, für Wafer aus zwei mit Silicium dotierten Galliumarsenid-Einkristallen, wobei beide Wafer eine vergleichbare Ladungsträgerkonzentration besitzen, sich aber dadurch unterscheiden, daß entweder kein zusätzliches Bor und kein zusätzliches überstöchiometrisches Gallium zugesetzt wurde (Vergleich links) oder bewußt Bor und überstöchiometrisches Gallium jeweils in passenden Mengen zugesetzt wurden (gemäß einer Ausführungsform des erfinderischen Verfahrens rechts).
Fig. 2 zeigt die Abhängigkeit des optischen Transmissionskoeffizienten αₜ von der Ladungsträgerkonzentration n für zwei mit Silicium dotierte Galliumarsenidkristalle, die aus Schmelzen mit einem Arsen-Molenbruch *x*_{As} / (*x*_{As} + *x*_{Ga}) von 0,50 bzw. 0,48 erstarrt wurden.
Fig. 3 zeigt die Abhängigkeit der Konzentration von EL2-Defekten von der Ladungsträgerkonzentration für die in Fig. 2 dargestellten beiden Kristalle.

Ein signifikanter, verfahrens-relevanter Beitrag zur Erzielung der Effekte der Erfindung wird durch Beachtung eines molaren Überschusses an Gallium gegenüber Arsen in der Galliumarsenidschmelze geleistet, wobei dieser Beitrag erst dann wirksam zum Tragen kommt und dort zu einem synergistischen Effekt führt, wenn die Ladungsträgerkonzentration in einem Bereich von ≤ 1x10¹⁸cm⁻³ und vor allem in einem Bereich von ≤ 5x10¹⁷cm⁻³ liegt. Ein günstiger Einfluß auf die Erniedrigung des optischen Absorptionskoeffizienten wird insbesondere dann erhalten, wenn der molare Überschuss an Gallium in der Galliumarsenidschmelze vor Beginn der Erstarrung von 0,01 bis 2 mol% beträgt. Der genannte stöchiometrische Überschuß an Gallium gegenüber Arsen sollte spätestens beim Beginn der Erstarrung der Galliumarsenidschmelze herrschen. Zweckmäßiger weise geschieht dies durch Zugabe einer passenden überstöchiometrischen Menge an Gallium zu den Ausgangsmaterialien in den Tiegel vor dem Aufschmelzen des Ausgangsmaterials.

Das erfindungsgemäße Verfahren wird vorzugsweise so ausgeführt und entsprechend ein Galliumarsenid-Einkristall so erhalten, dass durch die Dotierung der Galliumarsenid-Einkristall eine Leitfähigkeit vom n-Typ aufweist. In diesem Fall kann die gewünschte Kombination aus relativ hoher Konzentration an Ladungsträger, die in diesem Fall durch die Elektronenkonzentration bereitgestellt wird, und niedrigem Absorptionskoeffizienten besonders wirksam erhalten werden. Der hierzu am besten geeignete Dotierstoff ist Silicium (Si), elementar oder chemisch gebunden. Im Vergleich zu nur halbisolierendem Galliumarsenid wird eine für die Anwendung wichtige, deutlich bessere Leitfähigkeit erreicht, und gegenüber einer Leitfähigkeit vom p-Typ ist der optische Absorptionskoeffizient - bei vergleichbarer Ladungsträgerkonzentration - viel kleiner, wenn der erfindungsgemäße Galliumarsenid vom n-Typ ist.

Mögliche zu Si alternative oder zu Si additive Dotierstoffe sind andere Elemente der Gruppen II, IV und VI des Periodensystems der Elemente, die sich jeweils auf die Leitfähigkeit des Galliumarsenid-Einkristalls auswirken, wie Beryllium (Be), Magnesium (Mg), Germanium (Ge), Kohlenstoff (C), Tellur (Te), Schwefel (S) und Selen (Se), aber auch Elemente der Nebengruppen wie Zink (Zn), Zinn (Sn), Cadmium (Cd) und dergleichen, jeweils alleine oder in Mischung, und jeweils elementar oder chemisch gebunden. Unabhängig vom den verwendeten Dotierstoffen ist jedoch besonders darauf zu achten, daß die erhaltene Ladungsträgerkonzentration 1×10¹⁸ cm⁻³ und insbesondere 5x10¹⁷ cm⁻³ nicht übersteigt und gleichzeitig der hier definierte stöchiometrische Überschuß von Gallium gegenüber Arsen eingehalten wird, um die gewünschten Parameter des optischen Absorptionskoeffizienten erreichen zu können. Im Hinblick auf das Erreichen von niedrigen optischen Absorptionskoeffizienten ist Silicium als Dotierstoff deutlich bevorzugt. Der ergänzende Zusatz von mehreren weiteren Dotierstoffen, etwa ergänzend zu Si und dem unten beschriebenen erwünschten Zusatz von Bor, ist z.B. der weitere Zusatz von sowohl Zn als auch In zu vermeiden. Ferner ist das Verhältnis von Si zu einem anderen, p-Leitung verursachenden Dotierstoff vorzugsweise > 1, weiter bevorzugt > 10.

Die Zugabemenge des Dotierstoffs wird sich danach richten, daß die Ladungsträgerkonzentration im erhaltenen, erstarrten Galliumarsenid-Einkristall zweckmäßig mindestens 1·10¹⁵ cm⁻³, bevorzugt mindestens 1·10¹⁶ cm⁻³, und insbesondere mindestens 1·10¹⁷ cm⁻³ beträgt.

Ein wichtiges Merkmal des erfindungsgemäßen Verfahrens besteht darin, für eine ausreichende Borkonzentration in der Galliumarsenid-Schmelze zu sorgen. Geeigneterweise wird zur Einstellung der zu beachtenden Bormenge Bor zu dem Galliumarsenid-Ausgangsmaterial, und/oder zu der Galliumarsenid-Schmelze zugegeben wird. Optional und weiter bevorzugt kann Bor ergänzend durch Vorsehen einer Boroxid-Abdeckschmelze über der Galliumarsenid-Schmelze eingetragen werden, um insgesamt für die gewünschte Borkonzentration zu sorgen. Dadurch ist es möglich, eine für die Erniedrigung des optischen Absorptionskoeffizienten wichtige Erniedrigung der Dotierstoffkonzentration so zu kompensieren, daß ein passender und die Leistungsparameter des mit dem Wafer gefertigten

Bauteils genügender Ladungsträgerkonzentrationsbereich erhalten wird. Ein zusätzlicher vorteilhafter Effekt besteht darin, daß in Kombination eine niedrige Versetzungsdichte erhältlich ist. Entsprechend besitzt der erhaltene Galliumarsenid-Einkristall bevorzugt einen Borgehalt von mindestens 5×10¹⁷ cm⁻³, weiter bevorzugt mindestens 1×10¹⁸ cm⁻³ und insbesondere mindestens 2×10¹⁸ cm⁻³. Weitere mit einem Einbau von Bor in den erfindungsgemäßen Galliumarsenid-Einkristall - und damit in den daraus vereinzelten Wafer - verbundene Vorteile beruhen darauf, daß die zur Versetzungsbildung aufzubringende Energiebarriere deutlich ansteigt, was durch eine Begrenzung der Flächendichte von Versetzungsätzgruben auf Querschnittsflächen senkrecht zur Kristallachse von höchstens 1500 cm⁻², bevorzugt von höchstens 500 cm⁻² zum Ausdruck kommt.

Gemäß einer bevorzugten Weiterbildung des erfindungsgemäßen Verfahrens erfolgt das Schmelzen und Erstarren bevorzugt in einem Tiegel unter Verwendung eines Keimkristalls aus Galliumarsenid. Diese Verfahrensführung erlaubt eine effiziente Kristallbildung insbesondere in der kritischen Anfangsphase der Kristallbildung, und sie erlaubt eine Einstellung einer zu beachtenden Bormenge im Laufe des Schmelz- und Erstarrungsvorgangs und trägt so zum Erreichen des gewünschten Ergebnisses bei. Das für die Erfindung anzuwendende Verfahrensprinzip beruht stark bevorzugt auf einer gerichteten Erstarrung, beispielsweise nach der Vertical Gradient Freece - Methode (VGF) oder der Vertical Bridgman - Methode (VB).

Der gesamte Absorptionskoeffizient αₜ im Wellenlängenbereich von 900 nm bis 4 µm ergibt sich aus der Summe der Absorptionsquerschnitte α_{ib} und α_{EL2}.

Ein geringer Absorptionskoeffizient αₜ kann erreicht werden durch eine Verringerung der Ladungsträgerkonzentration, durch eine Verringerung der Konzentration der EL2-Defekte oder durch beide Maßnahmen. Einer Verringerung der Ladungsträgerkonzentration sind jedoch Grenzen gesetzt. Für die Funktion der lichtemittierenden Bauelemente ist in der Regel eine hohe elektrische Leitfähigkeit der Substratwafer, insbesondere eine solche vom n-Typ erforderlich, die durch eine geeignete Dotierung erreicht wird. Die Ladungsträgerkonzentration beträgt in der Regel mindestens 1.10¹⁵ cm⁻³, bevorzugt mindestens 1.10¹⁶ cm⁻³, und insbesondere mindestens 1·10¹⁷ cm⁻³. Eine weitere Verringerung des optischen Absorptionskoeffizienten kann also nur dadurch erfolgen, daß ein Absenken der Konzentration von EL2-Defekten in Kombination beachtet wird. Das System ist vorteilhafter weise so zu beeinflussen, dass die EL2-Konzentration bevorzugt unter 1.10¹⁶ cm⁻³, weiter bevorzugt unter 5·10¹⁵ cm⁻³ und insbesondere unter 1·10¹⁵ cm⁻³ liegt.

Übliche Verfahren zur Herstellung von Einkristallen aus Galliumarsenid verwenden zur Verhinderung des Abdampfens von Arsen von der Galliumarsenidschmelze eine Abdeckschmelze aus Boroxid (B₂O₃). Zur Herstellung von Galliumarsenidkristallen mit einer hohen elektrischen Leitfähigkeit, insbesondere solche vom n-Typ, wird ein geeigneter Dotierstoff wie z.B. Silicium verwendet. Ein Hinzufügen von Dotierstoff wie Silicium zur Galliumarsenidschmelze in Konzentrationen, wie sie zur Einstellung einer wünschenswerten Ladungsträgerkonzentration in den erzeugten Kristallen, z.B. von mindestens 1· 10¹⁶ cm⁻³, erforderlich ist, ruft eine Reaktion des Dotierstoffs wie Siliciums mit der Boroxidabdeckschmelze hervor. Ein Teil des Dotierstoffs wird oxidiert, woraufhin sich das entstehende Bor in der Galliumarsenidschmelze löst. Dieser Eintrag von Bor in die Schmelze führt zu einer Bor-Verunreinigung der erzeugten Kristalle. Die Konzentration von Bor in den Kristallen ist dabei in der Regel vergleichbar zur Konzentration des Dotierstoffs Silicium, wie z.B. in [17] für Silicium als Dotierstoff gezeigt wird. Diese unabsichtlich, als Verunreinigung eingetragene Konzentration von Bor führt in Galliumarsenidkristallen, insbesondere bei n-leitenden, Silicium-dotierten Kristallen, zu einer Härtung des Kristallgitters.

Beträgt die beabsichtigte Ladungsträgerkonzentration der Galliumarsenidkristalle weniger als 1·10¹⁸ cm⁻³ und vor allem weniger als 5·10¹⁷cm⁻³, wie es sich zur Einstellung eines geringen optischen Absorptionskoeffizienten als kritisch erwiesen hat, so ist die zur Galliumarsenidschmelze hinzugegebene Menge eines geeigneten Dotierstoffs wie Silicium so klein, dass die infolge der chemischen Reaktion zwischen Dotierstoff und Boroxidabdeckschmelze in die Galliumarsenid-Schmelze eingetragene Menge an Bor typischerweise zu gering ist, um die oben genannten, Bor zuzuschreibenden Wirkungen, einschließlich einer wirksame Härtung des Gitters und damit eine Verringerung der Versetzungsdichte, auf erwünschte Werte zu erreichen. Dies gilt besonders in Fällen, in denen die Flächendichte von Versetzungsätzgruben auf Querschnittsflächen senkrecht zur Kristallachse weniger als 1500 cm⁻² betragen sollen, und vor allem in Fällen, in denen diese noch weniger, z.B. < 500 cm⁻² betragen sollen. Dies kann erfindungsgemäß dadruch kompensiert werden, dass bei der Herstellung von dotierten Galliumarsenidkristallen, insbesondere bei Silicium-dotierten Galliumarsenidkristallen, die zu Ladungsträgerkonzentrationen von weniger als 1·10¹⁸cm⁻³ und vor allem von weniger als 5·10¹⁷ cm⁻³ im Produkt führen sollen, zusätzlich Bor hinzugegeben werden, so daß die Borkonzentration in der Galliumarsenid-Schmelze und damit im erstarrten Kristall mindestens 5·10¹⁷ cm⁻³ beträgt.

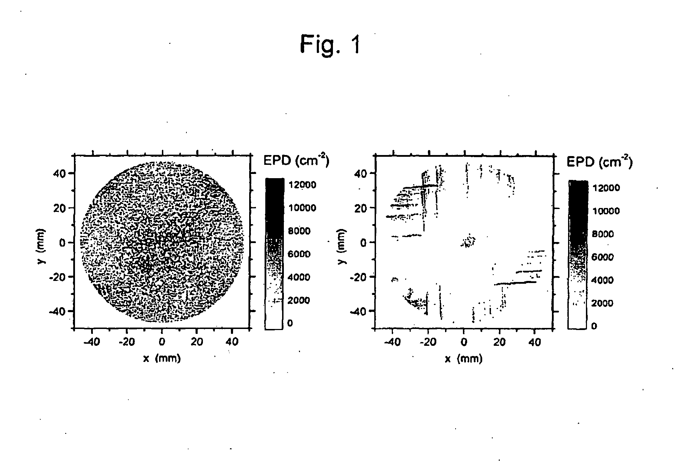

Beschreibung von nicht einschränkenden Beispielen gemäß bevorzugten Ausführungsformen:
Zur Herstellung eines mit Silicium dotierten Galliumarsenidkristalls nach dem herkömmlichen Verfahren wurde eine Menge von 9 kg stöchiometrisches, polykristallines Galliumarsenid und 1,3 g elementares Silicium in einen zylindrisch geformten, einseitig geschlossenen Tiegel aus pyrolytisch abgeschiedenem Bornitrid (pBN) gegeben. Dieser Tiegel wies am geschlossenen Ende eine Verjüngung auf, an die sich ein weiterer zylindrischer Abschnitt kleineren Durchmessers anschloss, in den ein Galliumarsenid-Keimkristall eingesetzt wurde. Der Tiegelinhalt wurde mit einer zylindrischen Platte aus Boroxid abgedeckt. In einer Vertical-Gradient-Freece (VGF) Kristallzüchtungsanlage, wie sie in [18] beschrieben ist, wurden der Tiegel und sein Inhalt durch außerhalb des Tiegels angeordnete Heizelemente so erhitzt, dass das polykristalline Galliumarsenid und das Boroxid aufgeschmolzen wurden und das Silicium in der Galliumarsenidschmelze gelöst wurde. Anschließend wurde durch geeignete Steuerung der Heizelemente das Temperaturfeld innerhalb des Tiegels so verändert, dass ausgehend vom Keimkristall eine gerichtete Erstarrung der Galliumarsenid-Schmelze stattfand. Der erstarrte Kristall wurde auf Raumtemperatur abgekühlt und sein zylindrischer Teil zu Wafern verarbeitet. Ein Wafer aus dem keimnahen Bereich des Kristallzylinders (Ingot) wies eine Ladungsträgerkonzentration von 1,0·10¹⁷ cm⁻³, eine Versetzungsätzgrubendichte von 3820 cm⁻² (siehe Figur 1 linke Abbildung), einen Borgehalt von 1,5·10¹⁷ cm⁻³ und einen optischen Absorptionskoeffizienten bei einer Wellenlänge von 1046 nm von 2,2 cm⁻³ auf.
Zur Herstellung eines Kristalls nach dem erfindungsgemäßen Verfahren wurde im Unterschied zum oben beschriebenen herkömmlichen Verfahren zusätzlich eine Menge von 370 g an elementarem Gallium in den Tiegel gegeben, um einen galliumreiche Galliumarsenid-Schmelze mit einem Arsen-Molenbruch von 0,48 zu erzeugen. Die Schmelze wurde wie beim herkömmlichen Verfahren durch Zugabe von 1,3 g elementarem Silicium, im weiteren Unterschied dazu aber zusätzlich durch Zugabe von 0,46 g elementarem Bor dotiert. Die Erstarrung der Schmelze wurde, wie für das herkömmliche Verfahren beschrieben, durchgeführt. Ein Wafer aus dem keimnahen Bereich des Kristallzylinders (Ingot) wies eine Ladungsträgerkonzentration von 1,3·10¹⁷ cm⁻³, eine Versetzungsätzgrubendichte von 470 cm⁻² (siehe Figur 1 rechte Abbildung), einen Borgehalt von 2,1·10¹⁸ cm⁻³ und einen optischen Absorptionskoeffizienten bei einer Wellenlänge von 1046 nm von 1,8 cm⁻¹ auf.

In Figur 1 werden Topogramme der lokalen Versetzungsätzgrubendichte, die als Maß für die Versetzungsdichte dient, für Wafer aus zwei mit Silicium dotierten Kristallen gezeigt, wie sie vorstehend beschrieben erhalten wurden. Die beiden Wafer besitzen eine vergleichbare Ladungsträgerkonzentration von 1,0·10¹⁷ cm⁻³ bzw. 1,3·10¹⁷ cm⁻³ und stammen jeweils aus dem keimnahen Bereich des zylindrischen Teils der Kristalle. Die lokale EPD wurde flächendeckend in Messfeldern mit einer Abmessung von 0,5 mm x 0,5 mm gemessen.

Ergebnisse:
Links: Mittelwert der EPD = 3820 cm⁻², Ladungsträgerkonzentration *n* = 1,0·10¹⁷ cm⁻³, Borgehalt = 1,5·10¹⁷ cm⁻³
Rechts: Mittelwert der EPD = 470 cm⁻², Ladungsträgerkonzentration *n* = 1,3·10¹⁷ cm⁻³, Borgehalt = 2.1·10¹⁸ cm⁻³

Die Versetzungsätzgrubendichte des Wafers aus dem nicht gezielt mit Bor dotierten Kristall betrug 3820 cm⁻². Die Versetzungsätzgrubendichte des Wafers aus dem Kristall, der gezielt mit einer End-Borkonzentration von 2,1·10¹⁸ cm⁻³ dotiert wurde, betrug demgegenüber nur 470 cm⁻². Dieser Wafer erfüllt daher die Zielstellung einer geringen Ladungsträgerkonzentration von weniger als 5·10¹⁷ cm⁻³ bei einer gleichzeitig geringen Versetzungsdichte von weniger als 500 cm⁻².

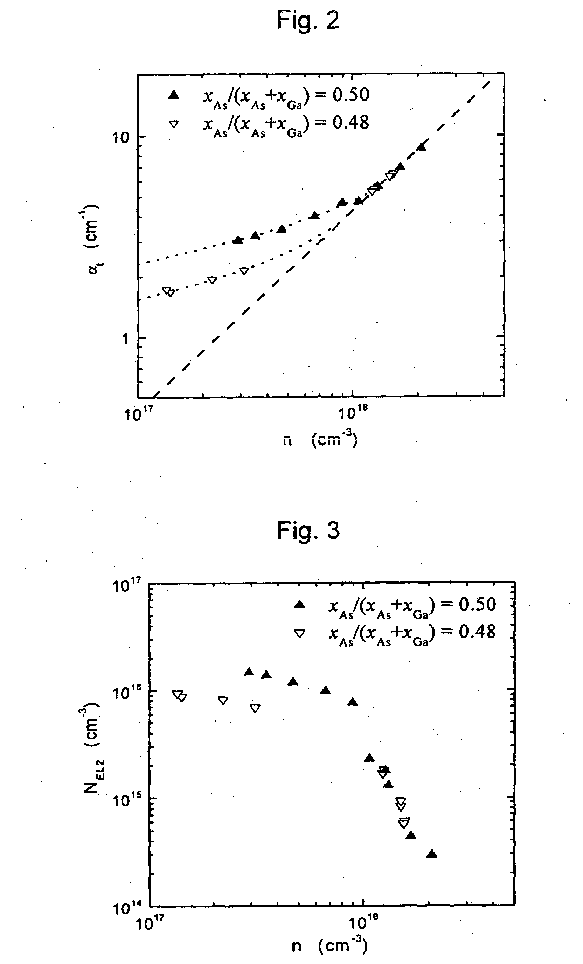

In Figur 2 wird die Abhängigkeit des optischen Transmissionskoeffizienten αₜ von der Ladungsträgerkonzentration *n* für zwei mit Silicium dotierte Galliumarsenidkristalle gezeigt, die aus Schmelzen mit einem Arsen-Molenbruch *x*_{As} / (*x*_{As} + *x*_{Ga}) von 0,50 bzw. 0,48 erstarrt wurden. Die Meßwerte wurden an Proben ermittelt, die aus beidseitig chemisch-mechanisch polierten Wafern präpariert wurden. Dazu wurde jeweils aus einem nahezu versetzungsfreien Gebiet eines Wafers durch Spalten ein quadratisches Stück mit einer lateralen Abmessung von 20×20 mm² entnommen. Die Messung der Ladungsträgerkonzentration *n* erfolgte mit Hilfe der van-der-Pauw- und Hall-Methode. Der optische Absorptionskoeffizient (optischer Transmissionskoeffizient) αₜ wurde bei einer Wellenlänge von 1046 nm in Abhängigkeit von der Ladungsträgerkonzentration *n* mit Hilfe eines optischen Transmissionstopographs nach [13] bestimmt.

Die gestrichelte Linie entspräche einer direkten Proportionalität zwischen n und αₜ, die für Proben gilt, in denen die Konzentration an EL2-Defekten vernachlässigbar klein ist. Die Ladungsträgerkonzentration der beiden Kristalle stieg in axialer Richtung vom Keimende ausgehend an, so dass von beiden Kristallen Proben mit unterschiedlichen Ladungsträgerkonzentiationen gewonnen werden konnten.

Die gestrichelte Linie in Figur 2 entspricht somit einer direkten Proportionalität zwischen αₜ und *n*. Der Proportionalitätsfaktor beträgt bei einer Wellenlänge von 1046 nm 4,36·10⁻¹⁶ cm². Die Proportionalität der beiden Größen tritt dann auf, wenn die Absorption durch EL2-Defekte vernachlässigbar klein ist, d.h. die Konzentration der EL2-Defekte deutlich unter 1·10¹⁵ cm⁻³ liegt. In diesem Fall beträgt der durch EL2 verursachte Absorptionskoeffizient α_{EL2} weniger als 0.125 cm⁻¹. Die gesamte beobachtete Absorption ist auf die Streuung von Photonen an Elektronen im Leitungsband zurückzuführen. Für niedrige Werte von *n* weichen die Messpunkte für beide Kristalle deutlich von der Proportionalität ab. Das bedeutet, dass in den betreffenden Proben ein Teil der Absorption von EL2-Defekten verursacht wird. Für den Kristall, der aus einer Schmelze mit einem Arsen-Molenbruch von 0,50 erstarrt wurde, ist die Abweichung von der Proportionalität zwischen αₜ und *n* stärker als im anderen Kristall, da die EL2-Konzentration höher als in diesem ist (siehe auch Figur 3).

In Figur 3 ist die Abhängigkeit der Konzentration von EL2-Defekten *N*_{EL2} von der Ladungsträgerkonzentration *n* für diese beiden Kristalle dargestellt, die aus Schmelzen mit einem Arsen-Molenbruch *x*_{As} / (*x*_{As} + *x*_{Ga}) von 0.50 bzw. 0.48 erstarrt wurden. Die EL2-Konzentration wurde folgendermaßen erhalten: Für jede Probe wurde aus der Ladungsträgerkonzentration *n* unter Verwendung des Proportionalitätsfaktors von 4.36·10⁻¹⁶ cm² der Absorptionskoeffizient α_{ib} berechnet. Dieser Wert wurde vom gemessenen Absorptionskoeffizienten αₜ subtrahiert. Die Differenz entspricht der durch EL2-Defekte verursachten Absorption und wurde mit dem Absorptionsquerschnitt nach [7] von 1.25·10⁻¹⁶ cm² in einen Konzentrationswert der EL2-Defekte umgerechnet.

Die Figuren 2 und 3 zeigen exemplarisch für eine Wellenlänge von 1046 nm, dass sich durch eine Verringerung des Arsengehalts der Schmelze, aus der ein Galliumarsenidkristall erstarrt wird, der optische Absorptionskoeffizient des Halbleitermaterials verringern lässt. Diese Verringerung ist der Abnahme der Konzentration der EL2-Defekte geschuldet. Mit dem erfindungsgemäßen Verfahren gelingt es also, Kristalle zu erzeugen, die sowohl die gewünschte hohe Leitfähigkeit, insbesondere vom n-Typ, gekennzeichnet durch eine Ladungsträgerkonzentration von mindestens 1·10¹⁵ cm⁻³ und sogar von mindestens 1·10¹⁶ cm⁻³, ais auch einen geringen optischen Absorptionskoeffizient im nahen Infrarot aufweisen.

Auf die folgende Patent- und Nichtpatent-Literatur wird in dieser Anmeldung Bezug genommen:
[1] A. S. Jordan,
   Determination of the total emittance of n-type GaAs with application to Czochralski growth, Journal of Applied Physics 51, 4 (1980) 2218-2227
[2] W. G. Spitzer, J. M. Whelan Infrared absorption and electron effective mass in n-type gallium arsenide Physical Review 114, 1 (1959) 59 - 63
[3] J. S. Blakemore Semiconducting and other major properties of gallium arsenide Journal of Applied Physics 53, 10 (1982) R123 - R180
[4] G. M. Martin Optical assessment of the main electron trap in bulk semi-insulating GaAs Applied Physics Letters 39, 9 (1981) 747 - 748
[5] K. Elliot, R. T. Chen, S. G. Greenbaum, R. J. Wagner Identification of AsGa antisite defects in liquid encapsulated Czochralski GaAs Applied Physics Letters 44, 9 (1984) 907 - 909
[6] M. Bäumler, U. Kaufmann, J. Windscheif Photoresponse of the AsGa antisite defect in as-grown GaAs Applied Physics Letters 45, 8 (1985) 781 - 783
[7] P. Silverberg, P. Omling, L. Samuelson Hole photoionization cross sections of EL2 in GaAs Applied Physics Letters 52, 20 (1988) 1689 - 1691
[8] G. M. Martin, J. P. Farges, G. Jacob, J. P. Hallais Compensation mechanisms in GaAs Journal of Applied Physics 51, 5 (1980) 2840 - 2852
[9] JP,11-268998,A *Gallium arsenic singe crystal ingot, ist production, and gallium arsenic single crystal wafer using the same*
[10] D. E. Holmes, R. T. Chen, K. R. Elliot, C. G. Kirkpatrick Stoichiometry-controlled compensation in liquid encapsulated Czochralski GaAs Applied Physics Letters 40, 1 (1982) 46 - 48
[11] J. Lagowski, H. C. Gatos, J. M. Parsey, K. Wada, M. Kaminska, W. Walukiewicz Origin of the 0.82-eV electron trap in GaAs and its annihilation by shallow donors Applied Physics Letters 40, 4 (1982) 342 - 344
[12] D. T. J. Hurle A comprehensive thermodynamic analysis of native point defect and dopant solubilities in gallium arsenide Journal of Applied Physics 85, 10 (1999) 6957 - 7022
[13] M. Wickert Physikalische Mechanismen der Homogenisierung elektrischer Eigenschaften von GaAs-Substraten Dissertation, Fakultät für Mathematik und Physik der Albert-Ludwigs-Universität Freiburg i. Br., 1998
[14] US 7,214,269 *Si-doped GaAs Single Crystal Substrate*
[15] JP 2000-086398
   *P-Type GaAs Single Crystal and its Production*
[16] US 2004-0187768
   *P-Type GaAs Single Crystal and its Production Method*
[17] US 5,612,014
   *Compound Semiconductor Crystal*
[18] J. Stenzenberger, T. Bünger, F. Börner, S. Eichler, T. Flade, R. Hammer, M. Jurisch, U. Kretzer, S. Teichert, B. Weinert Growth and characterization of 200 mm SI GaAs crystals grown by the VGF method Journal of Crystal Growth 250 (2003) 57 - 61

## Patentansprüche

1. Verfahren zur Herstellung eines dotierten Galliumarsenid-Einkristalls mit einer Ladungsträgerkonzentration von höchstens 1×10¹⁸ cm⁻³ durch Schmelzen eines Galliumarsenid-Ausgangsmaterials und anschließender Erstarrung der Galliumarsenid-Schmelze, **dadurch gekennzeichnet,**
**dass** die Galliumarsenid-Schmelze gegenüber der stöchiometrischen Zusammensetzung vor Beginn der Erstarrung einen Überschuss von 0,01 bis 2 mol% an Gallium enthält,
und **dass** Bor zusätzlich zu dem Galliumarsenid-Ausgangsmaterial und/oder zu der Galliumarsenid-Schmelze zugegeben wird, wobei für eine Borkonzentration im erhaltenen Kristall von mindestens 5×10¹⁷ cm⁻³ gesorgt wird.

2. Verfahren nach Anspruch 1, **dadurch gekennzeichnet, dass** ein dotierter Galliumarsenid-Einkristall mit einer Leitfähigkeit vom n-Typ hergestellt wird.

3. Verfahren nach Anspruch 1 oder 2, **dadurch gekennzeichnet, dass** das Schmelzen und Erstarren in einem Tiegel unter Verwendung eines Keimkristalls aus Galliumarsenid erfolgt.

4. Verfahren nach einem der vorangehenden Ansprüche, **dadurch gekennzeichnet, dass** Bor ergänzend durch Vorsehen einer Boroxid-Abdeckschmelze über der Galliumarsenid-Schmelze eingetragen wird, um insgesamt für die Borkonzentration zu sorgen.

5. Verfahren nach einem der vorangehenden Ansprüche, **dadurch gekennzeichnet, daß** der erhaltene, dotierte Galliumarsenid-Einkristall zu Galliumarsenid-Substratwafern vereinzelt wird.

6. Galliumarsenid-Einkristall mit einer Ladungsträgerkonzentration von mindestens 1×10¹⁶ cm⁻³ und höchstens 5×10¹⁷ cm⁻³ und einem optischen Absorptionskoeffizienten von höchstens 2,5 cm⁻¹ bei einer Wellenlänge von 1000 nm, von höchstens 1,8 cm⁻¹ bei einer Wellenlänge von 1100 nm und höchstens 1,0 cm⁻¹ bei einer Wellenlänge von 1200 nm,
wobei die EL 2-Konzentration unter 10¹⁶ cm⁻³ liegt, die Borkonzentration mindestens 5x10¹⁷ cm⁻³ beträgt, und die Flächendichte von Versetzungsätzgruben auf Querschnittsflächen senkrecht zur Kristallachse 1500 cm⁻² nicht übersteigt.

7. Galliumarsenid-Einkristall mit einer Elektronenkonzentration von mindestens 1×10¹⁵ cm⁻³ und höchstens 5×10¹⁷ cm⁻³ und einem optischen Absorptionskoeffizienten von höchstens 2,0 cm⁻¹ bei einer Wellenlänge von 1000 nm, von höchstens 1,4 cm⁻¹ bei einer Wellenlänge von 1100 nm und höchstens 0,8 cm⁻¹ bei einer Wellenlänge von 1200 nm,
wobei die EL 2-Konzentration unter 10¹⁶ cm⁻³ liegt, und die Borkonzentration mindestens 5×10¹⁷ cm⁻³ beträgt, und die Flächendichte von Versetzungsätzgruben auf Querschnittsflächen senkrecht zur Kristallachse 1500 cm⁻² nicht übersteigt.

8. Galliumarsenid-Einkristall gemäß Anspruch 6 oder 7 mit einer Leitfähigkeit vom n-Typ, wobei die angegebene Ladungsträgerkonzentration der Elektronenkonzentration entspricht.

9. Galliumarsenid-Einkristall gemäß einem der Ansprüche 6 bis 8, **gekennzeichnet durch** einen Borgehalt von mindestens 1×10¹⁸ cm⁻³.

10. Galliumarsenid-Einkristall gemäß einem der Ansprüche 6 bis 9, **dadurch gekennzeichnet, dass** die Flächendichte von Versetzungsätzgruben auf Querschnittsflächen senkrecht zur Kristallachse 500 cm⁻² nicht übersteigt.

11. Galliumarsenid-Substratwafer, gebildet aus einem Galliumarsenid-Einkristall gemäß einem der Ansprüche 6 bis 10.

12. Verwendung eines Galliumarsenid-Substratwafers gemäß Anspruch 11 zur Herstellung optoelektronischer Bauelemente, bei denen die erzeugte Strahlung den Substratwafer parallel oder senkrecht zur Waferoberfläche durchläuft.

## Claims

1. A process for producing a doped gallium arsenide single crystal having a charge carrier concentration of at most 1x10¹⁸ cm⁻³, by melting a gallium arsenide starting material and subsequently solidifying the gallium arsenide melt, **characterized in that** the gallium arsenide melt contains, before starting solidification, an excess of 0.01 to 2 mole-% of gallium relative to the stoichiometric composition, and
that boron is added to the gallium arsenide starting material and/or to the gallium arsenide melt, wherein a boron concentration of at least 5x10¹⁷ cm⁻³ is provided for in the obtained crystal.

2. The process according to claim 1, **characterized in that** a doped gallium arsenide single crystal having a n-type conductivity is produced.

3. The process according to claim 1 or 2, **characterized in that** the melting and solidifying is carried out in a crucible using a seed crystal made of gallium arsenide.

4. The process according to one of the preceding claims, **characterized in that** boron is additionally incorporated by providing a boron oxide cover layer above the gallium arsenide melt, in order to provide for the boron concentration in its entirety.

5. The process according to one of the preceding claims, **characterized in that** the obtained doped gallium arsenide single crystal is individualized into gallium arsenide substrate wafers.

6. A gallium arsenide single crystal having a charge carrier concentration of at least 1x10¹⁶ cm⁻³ and at most 5x10¹⁷ cm⁻³ and an optical absorption coefficient of at most 2.5 cm⁻¹ at a wavelength of 1000 nm, of at most 1.8 cm⁻¹ at a wavelength of 1100 nm and at most 1.0 cm⁻¹ at a wavelength of 1200 nm,
wherein the EL 2-concentration is below 10¹⁶ cm⁻³, the boron content is at least 5x10¹⁷ cm⁻³, and the area density of etch pitches on cross-sections perpendicular to the crystal axis does not exceed 1500 cm⁻².

7. A gallium arsenide single crystal having an electron concentration of at least 1x10¹⁵ cm⁻³ and at most 5x10¹⁷ cm⁻³ and an optical absorption coefficient of at most 2.0 cm⁻¹ at a wavelength of 1000 nm, of at most 1.4 cm⁻¹ at a wavelength of 1100 nm and at most 0.8 cm⁻¹ at a wavelength of 1200 nm,
wherein the EL 2-concentration is below 10¹⁶ cm⁻³ and the boron content is at least 5x10¹⁷ cm⁻³, and the area density of etch pitches on cross-sections perpendicular to the crystal axis does not exceed 1500 cm⁻².

8. The gallium arsenide single crystal according to claim 6 or 7 having an n-type conductivity, wherein the indicated charge carrier concentration corresponds to the electron concentration.

9. The gallium arsenide single crystal according to any of the claims 6 to 8, **characterized by** a boron content of at least 1x10¹⁸ cm⁻³.

10. The gallium arsenide single crystal according to any one of claims 6 to 9, **characterized in that** the area density of etch pitches on cross-sections perpendicular to the crystal axis does not exceed 500 cm⁻².

11. A gallium arsenide substrate wafer, formed from a gallium arsenide single crystal according to one of claims 6 to 10.

12. A use of a gallium arsenide substrate wafer according to claim 11 for the manufacture of optoelectronic devices in which the generated radiation pass the substrate wafer parallel to or perpendicular to the wafer surface.

## Revendications

1. Procédé de production d'un monocristal d'arséniure de gallium dopé ayant une concentration en porteurs de charge d'au maximum 1 x 10¹⁸.cm⁻³ par fusion d'une matière de départ d'arséniure de gallium et solidification consécutive de la fonte d'arséniure de gallium, **caractérisé en ce que**
la fonte d'arséniure de gallium par rapport à la composition stoechiométrique avant le début de la solidification contient un excédent de 0,01 à 2 % en moles de gallium,
et **en ce que** le bore est ajouté en plus de la matière de départ d'arséniure de gallium et/ou de la fonte d'arséniure de gallium, une concentration en bore dans le cristal obtenu d'au moins 5 x 10¹⁷.cm⁻³ étant garantie.

2. Procédé selon la revendication 1, **caractérisé en ce qu'**un monocristal d'arséniure de gallium d'une conductivité de type n est produit.

3. Procédé selon la revendication 1 ou 2, **caractérisé en ce que** la fonte et la solidification s'effectuent dans un creuset en utilisant un germe cristallin constitué d'arséniure de gallium.

4. Procédé selon l'une des revendications précédentes, **caractérisé en ce que** le bore est apporté complémentairement en prévoyant une fonte de recouvrement d'oxyde de bore sur la fonte d'arséniure de gallium pour garantir globalement la concentration en bore.

5. Procédé selon l'une des revendications précédentes, **caractérisé en ce que** le monocristal d'arséniure de gallium dopé obtenu est coupé en tranches de substrat d'arséniure de gallium.

6. Monocristal d'arséniure de gallium ayant une concentration en porteurs de charges d'au moins 1 x 10¹⁶.cm⁻³ et d'au maximum 5 x 10¹⁷.cm⁻³ et un coefficient d'absorption optique d'au maximum 2,5 cm⁻¹ pour une longueur d'ondes de 1000 nm, d'au maximum 1,8 cm⁻¹ pour une longueur d'ondes de 1100 nm et d'au maximum 1,0 cm⁻¹ pour une longueur d'ondes de 1200 nm, la concentration EL 2 étant inférieure à 10¹⁶ cm⁻³, la concentration en bore étant d'au moins 5 x 10¹⁷ cm⁻³, et la densité surfacique des cavités de gravure décalées ne dépassant pas 1500 cm⁻² sur les surfaces transversales à l'axe des cristaux.

7. Monocristal d'arséniure de gallium ayant une concentration en électrons d'au moins 1 x 10¹⁵.cm⁻³ et d'au maximum 5 x 10¹⁷.cm⁻³ et un coefficient d'absorption optique d'au maximum 2,0 cm⁻¹ pour une longueur d'ondes de 1000 nm, d'au maximum 1,4 cm⁻¹ pour une longueur d'ondes de 1100 nm et d'au maximum 0,8 cm⁻¹ pour une longueur d'ondes de 1200 nm, la concentration EL 2 étant inférieure à 10¹⁶ cm⁻³ et la concentration en bore étant d'au moins 5 x 10¹⁷ cm⁻³, et la densité surfacique des cavités de gravure décalées ne dépassant pas 1500 cm⁻² sur les surfaces transversales à l'axe des cristaux.

8. Monocristal d'arséniure de gallium selon la revendication 6 ou 7 ayant une conductivité de type n, la concentration en porteurs de charge indiquée correspondant à la concentration en électrons.

9. Monocristal d'arséniure de gallium selon l'une des revendications 6 à 8, **caractérisé par** une teneur en bore d'au moins 1 x 10¹⁸.cm⁻³.

10. Monocristal d'arséniure de gallium selon l'une des revendications 6 à 9, **caractérisé en ce que** la densité surfacique des cavités de gravure décalées ne dépasse pas 500 cm⁻² sur les surfaces transversales à l'axe des cristaux.

11. Tranche de substrat d'arséniure de gallium formée à partir d'un monocristal d'arséniure de gallium selon l'une des revendications 6 à 10.

12. Utilisation d'une tranche de substrat d'arséniure de gallium selon la revendication 11 pour la production de composants optoélectroniques dans lesquels le rayon produit traverse la tranche substrat parallèlement ou perpendiculairement à la surface de la tranche.
